Europäisches Patentamt

European Patent Office

Office européen des brevets

(11) Publication number: **0 203 560**
**A1**

## EUROPEAN PATENT APPLICATION

(21) Application number: **86107133.0**

(51) Int. Cl.⁴: **H 01 L 21/306**

(22) Date of filing: **26.05.86**

(30) Priority: **31.05.85 US 739722**

(43) Date of publication of application: **03.12.86**
**Bulletin 86/49**

(84) Designated Contracting States: **DE FR GB**

(71) Applicant: **TEGAL CORPORATION, 11 Digital Drive, Novato California 94947 (US)**

(72) Inventor: **Giffen, Leslie, 8528 Windmill Farms, Cotati California 94928 (US)**
Inventor: **Stark, Mark M., 1-6-13 Jyonan, Fujisawa-shi Kanagawa Prefecture (JP)**

(74) Representative: **Ibbotson, Harold, Motorola Ltd Patent and Licensing Operations - Europe Jays Close Viables Industrial Estate, Basingstoke Hampshire RG22 4PD (GB)**

(54) **Plasma trench etch.**

(57) A trench is etched in silicon (14) using $CF_3Br$ gas in an annular flow plasma reactor (I). The reactor is operated in a triode mode with the upper electrode (II) grounded, the sidewall (13) driven by a high frequency signal (31) and the lower electrode (12) driven by a low frequency signal (32). A D.C. bias (34) may additionally be applied to the lower electrode.

EP 0 203 560 A1

-1-

# PLASMA TRENCH ETCH

## Background of the Invention

This invention relates to plasma etching and, in particular, to etching deep channels or trenches in silicon.

As known in the art, trenches which have been refilled with oxide are used to isolate devices in an integrated circuit. In order to assure isolation, the trenches are relatively deep, e.g. on the order of 3-15 microns. It is further desired that the etch be relatively uniform and produce vertical or nearly vertical sidewalls. For shallow grooves, these criteria are met relatively easily. For trenches, these criteria are more difficult. Further, the problem is compounded by the fact that, as device geometries are reduced, the width of the trench should also be reduced, in proportion if possible. Achieving uniform, vertical walls etc. in a narrow trench is more difficult because of the decreased aspect ratio (width to depth) of the trench.

Plasma reactors have been used for trench etches, with varying degrees of success. One problem which must be overcome is etch rate. Improved etch techniques are desired so that an etch two or more times as deep does not require twice as long to perform, or longer. Thus, it remains a problem to increase the etch rate, but not at the expense of uniformity or other parameters.

A wide variety of gases have been proposed or even used for various etch operations. The gases can be divided generally, although not precisely, by the operand, i.e. the layer or material being etched. For example, photoresist is usually etched in a plasma comprising oxygen, among other gases. Aluminum is typically etched in a chloride mixture, e.g. $BCl_3$. Silicon has perhaps the most gases proposed for the etching thereof. Usually, a member of the Freon family is included in the mixture.

Conversely, a particular gas or gas mixture may have been proposed for a variety of operands. For example, it is known in the art to use $CF_3Br$ for plasma etching. In U.S. Patent 4,374,698, a mixture comprising 1-15% $CF_3Br$ is used to etch silicon nitride using silicon dioxide as a mask. An improved selectivity is alleged for the addition of the $CF_3Br$. In U.S. Patent 4,226,665, a mixture of 70% $CF_3Br$ - 30% He is disclosed for etching silicon. An etch rate of about 600 angstroms per minute is alleged. In U.S. Patent 4,314,875, a mixture of 50% $CF_3Br$ - 50% $NF_3$ is disclosed as etching photoresist at the rate of about 700 angstroms per minute. Even ignoring the operand, the etch rates disclosed in these patents are not suited for trench etches because they are two slow. For example, a 6 micron (60,000 $A^O$) etch would take 100 minutes at 600 $A^O$ per minute.

In view of the foregoing, it is therefore an object of the present invention to provide an improved trench etch for silicon.

Another object of the present invention is to provide a rapid trench etch for silicon.

A further object of the present invention is to provide a rapid trench etch for silicon which is at least as uniform as prior art etches.

## Summary of the Invention

The foregoing objects are achieved in the present invention wherein $CF_3Br$ gas is used in a parallel plate, radial flow plasma reactor operated in a triode mode. The wafer is maintained at a temperature of 10-25$^O$C. The pressure in the chamber is maintained between 100 mtorr and 450 mtorr. The applied signals comprise 300-800 watts at 13.56 MHz, 100-200 watts at 100 KHz, and, optionally, a D.C. bias on the electrode in contact with the wafer. $H_2$ or $O_2$ gases can be added up to fifty percent by volume.

A more complete understanding of the present invention can be obtained by considering the following detailed description in conjunction with the accompanying drawings, in which:

Brief Description of the Drawings

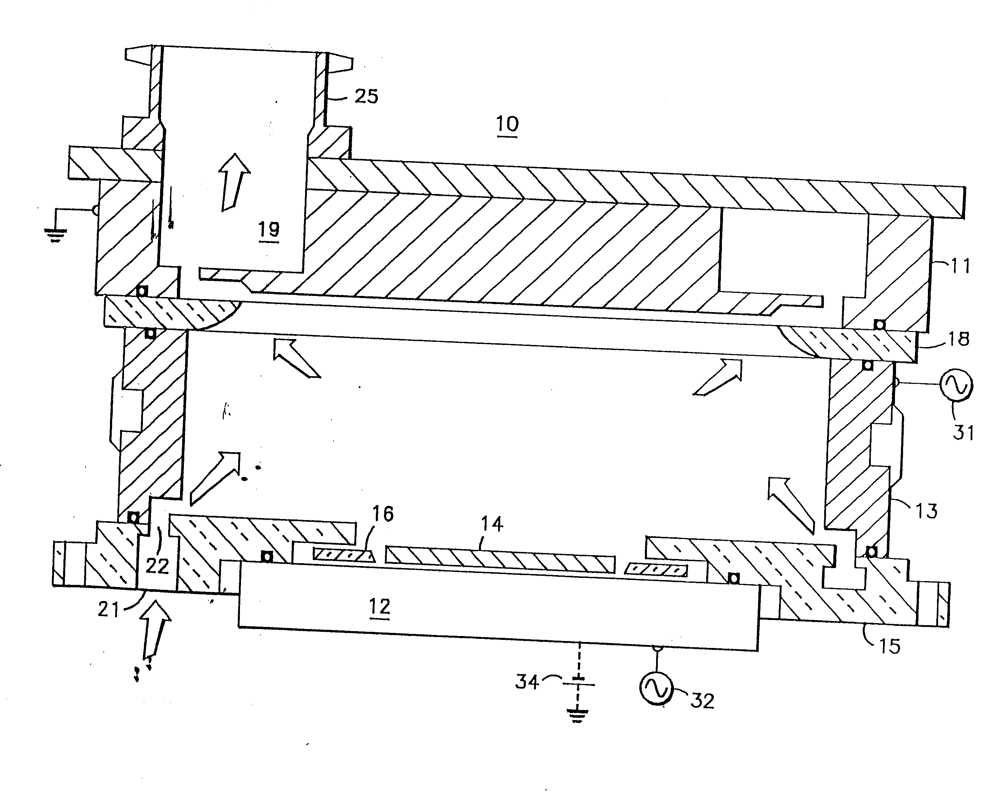

The FIGURE illustrates a parallel plate, annular flow plasma reactor for use in the present invention.

Detailed Description of the Invention

The FIGURE illustrates a preferred embodiment of a plasma reactor suitable for use in carrying out the present invention. Specifically, reactor 10 comprises what is known as a parallel plate reactor in which upper electrode 11 is generally planar and positioned opposite lower electrode 12. Separating the two electrodes is sidewall 13 which is electrically insulated from both electrodes. Specifically, insulating means 18 separates upper electrode 11 from sidewall 13 while frame member 15, which comprises a suitable ceramic, separates sidewall 13 from lower electrode 12. Wafer 14 rests on lower electrode 12 and is located within insulating ring 16, which serves to adapt frame member 15 and electrode 12 to various sized wafers by minimizing the amount of exposed upper surface on lower electrode 12.

Gas is supplied to the chamber by way of a suitable fitting in bore 21 formed in frame member 15. Bore 21 is coupled to an annular bore 22 which provides gas about the periphery of the lower portion of the chamber. The gas is exhausted through an aperture in insulator 18 to a gap formed between upper electrode 11 and insulator 18. The

gap extends to plenum 19 in upper electrode 11 where the gas is collected by a suitable exhaust means connected to fitting 25. As thus configured, reactor 10 is what is known as an annular flow reactor since the gases are supplied about the periphery of the lower electrode and exhausted about the periphery of the upper electrode.

In accordance with the present invention, reactor 10 is operated in what is known as the triode mode. Specifically, upper electrode 11 is grounded. Sidewall 13 is connected to source 31 of high frequency power. Lower electrode 12 is connected to source 32 of low frequency power. Optionally, one can provide a DC bias to wafer 14 by way of bias means 34, illustrated in the FIGURE as a battery. High frequency source 31 typically comprises a 13.56 MHz signal at 300-800 watts power. Source 32 typically comprises a 100 KHz signal at 100-200 watts.

In operation, a wafer is placed upon electrode 12 and lower electrode 12 is raised into position, as illustrated in the FIGURE, thereby closing the plasma reactor. The reactor chamber is evacuated and filled with a suitable gas, as described in more detail herein by way of particular examples. A plasma is then ignited by applying the signals from sources 31 and 32. After a predetermined length of time, or as determined by an end point detector (not shown), the plasma is terminated, the chamber is returned to atmospheric pressure, and wafer 14 is removed.

The following examples are given to clearly describe the present invention. It is understood by those of skill in the art that the examples are illustrative only and not exhaustive of the scope of the present invention.

### Example 1

Single crystal silicon wafers having a mask layer comprising silicon dioxide were etched in a triode, annular flow reactor as described above except ceramic ring 36 was not used. The gas comprised $CF_3Br$ at 100 mtorr. The high frequency source provided 800 watts at 13.56 MHz. The low frequency source provided 200 watts at 100 KHz. The temperature of the lower electrode was maintained at 25$^{o}$C. The etch rate was about .45 microns per minute at a flow of 5 SCCM per minute and increased to about .6 microns per minute when the gas flow was increased to 10 SCCM per minute. Further increase in gas flow did not significantly increase the etch rate.

## Example 2

Under conditions as described above, the pressure was varied while the flow was maintained at 5 SCCM. At 100 mtorr, the etch rate was about .45 microns per minute with a uniformity of about 4 percent. At 200 mtorr, the etch rate was about .7 microns per minutes but the uniformity degraded to 10 percent. At 300 mtorr, the etch rate and uniformity were slightly higher.

## Example 3

Under conditions similar to Example 2, the applied RF signals were pulsed to obtain a fifty percent duty cycle and a period of 0.7 milliseconds. Ceramic ring 36 was also used and the lower electrode was held at 10$^{o}$C. At 100 mtorr, the etch rate was .60 microns per minute. At 200 microns, it was about .68 microns per minute. At 300 microns, it was about .75 microns per minute.

## Example 4

A single crystal silicon wafer was etched in a reactor as illustrated in the FIGURE using 5 SCCM of $CF_3Br$ at 400 mtorr. The applied powers were 500 watts continuous at 13.56 MHz and 100 watts continuous at 100 KHz. The lower

-6-

electrode was held at 10°C. A bias of -100 VDC was applied to the lower electrode. The calculated etch rate was 1 micron per minute with a uniformity of 6 percent.

In general, based on these and other experiments, pulsing the plasma decreased uniformity, as did increasing the pressure. Anisotropy was obtained. The trenches had smooth sidewalls and rounded bottoms. Adding chlorine to the gas mixture causes some bowing of the sidewalls. Argon or helium causes roughness in the sidewall. Adding nitrogen tends to cause undercutting. Oxygen or hydrogen can be added without ill effect.

There is thus provided by the present invention an improved etch process in which the etch rate is in excess of an order of magnitude higher than the prior art. Despite this considerable increase in etch rate, reasonable uniformity is obtained.

Having thus described the invention, it will be apparent to those of skill in the art that various modifications can be made within the spirit and scope of the present invention. One can add gases to accommodate particular layers or impurities exposed to the plasma, although the active gases should comprise at least 50% of the mixture.

CLAIMS

1. In a process for etching silicon in a parallel plate plasma reactor using $CF_3Br$ gas wherein the improvement comprises the steps of:
    providing $CF_3Br$ gas at a flow rate of from 1-15 SCCM and a pressure of 100-450 mtorr;
    causing a glow discharge in said reactor; and
    exposing a semiconductor wafer to said discharge.

2. The process as set forth in claim 1 and further including the step of:
    providing a gas selected from the group consisting essentially of oxygen and hydrogen in an amount not to exceed the amount of $CF_3Br$.

3. The process as set forth in claim 1 and further comprising the step of operating said reactor in a triode mode.

4. The process as set forth in claim 3 wherein a D.C. bias is applied to the lower electrode of said reactor.

5. The process as set forth in claim 4 wherein said glow discharge is caused by continuously applying RF power to said reactor.

6. The process as set forth in claim 4 wherein said glow discharge is caused by applying pulsed RF power to said reactor.

7. The process as set forth in claim 3 and further comprising step of:
    first placing said wafer on one electrode of said reactor.

8.    The process as set forth in claim 7 wherein said first step is preceded by

providing an insulating ring around said wafer.

.

10  11  18  31  13  15  32  34  25  19  16  14  12  22  21

**European Patent Office**

**EUROPEAN SEARCH REPORT**

**0 203 560**

Application number

EP 86 10 7133

## DOCUMENTS CONSIDERED TO BE RELEVANT

| Category | Citation of document with indication. where appropriate, of relevant passages | Relevant to claim | CLASSIFICATION OF THE APPLICATION (Int Cl 4) |
|---|---|---|---|
| X | APPLIED PHYSICS LETTERS, vol. 36, no. 9, 1st May 1980, pages 768-770, New York, US; S. MATSUO "Selective etching of Si relative to SiO2 without undercutting by CBrF3 plasma" * figure 3; page 769, right-hand column * | 1 | H 01 L 21/306 |
| A,D | US-A-4 314 875 (D. FLAMM) * column 4, lines 23-34; column 4, line 53 - column 5, line 16 * | 1,2,7 | |
| A | GB-A-2 026 395 (WESTERN ELECTRIC CO. INC.) * page 3, lines 62-65; page 4, lines 18-30; & US - A - 422 665 (Cat. A,D) * | 1 | |
| A | US-A-4 464 223 (G.J. GORIN) * abstract; figure 2, column 3, lines 67-68, column 4, lines 20-55 * | 3-5,7 | TECHNICAL FIELDS SEARCHED (Int. Cl 4) H 01 L 21/30 C 23 F 1/00 |

The present search report has been drawn up for all claims

| Place of search | Date of completion of the search | Examiner |
|---|---|---|
| BERLIN | 07-08-1986 | PRETZEL B.C. |